# EUROPEAN PATENT SPECIFICATION

(11) **EP 4 418 844 B1**
(45) Date of publication and mention of the grant of the patent: **30.09.2026**
(21) Application number: 21968508.8
(22) Date of filing: 21.12.2021
(51) Int. Cl.: H10B 63/00, H10N 70/00, H10N 70/20

(54) **RESISTIVE RANDOM ACCESS MEMORY AND MANUFACTURING METHOD THEREFOR**
RESISTIVER DIREKTZUGRIFFSSPEICHER UND HERSTELLUNGSVERFAHREN DAFÜR
MÉMOIRE VIVE RÉSISTIVE ET SON PROCÉDÉ DE FABRICATION

(43) Date of publication of application: 21.08.2024
(73) Proprietor: Huawei Technologies Co., Ltd., Shenzhen, Guangdong 518129 (CN)
(72) Inventor: LIU, Xixia, Shenzhen, Guangdong 518129 (CN); ZHOU, Xue, Shenzhen, Guangdong 518129 (CN); WANG, Xiaojie, Shenzhen, Guangdong 518129 (CN); QIN, Qing, Shenzhen, Guangdong 518129 (CN); JIAO, Huifang, Shenzhen, Guangdong 518129 (CN)
(74) Representative: Pfenning, Meinig & Partner mbB
(86) International application number: PCT/CN2021/140220
(87) International publication number: WO 2023/115357

(56) References cited:
- EP-A1- 3 331 038
- WO-A1-2014/158793
- CN-A- 103 579 280
- CN-A- 110 718 569
- CN-A- 111 312 895
- CN-A- 111 769 196
- CN-A- 112 687 793
- US-A1- 2007 215 852
- US-A1- 2009 072 216
- US-A1- 2014 264 245

## Description

### TECHNICAL FIELD

This disclosure relates to the electronic field, and more specifically, to a resistive random access memory and a manufacturing method thereof, and an electronic device.

### BACKGROUND

US 2007/0215852 A1 discloses devices and methods to form memory cell devices including a small contact area between a bottom electrode and a layer of programmable resistive material, such as phase change material.

EP 3 331 038 A1 discloses a resistive random access memory and a method for manufacture the resistive random access memory.

US 2009/0072216 A1 discloses a phase change memory cell array with self-converged bottom electrode and a method for manufacturing thereof.

US 2014/0264245 A1 discloses a resistive memory cell with trench-shaped bottom electrode.

As an integrated circuit technology develops to a node below 28 nanometers, the development of a nonvolatile memory such as a traditional flash memory encounters a bottleneck. An important reason is that as a tunneling oxide layer channel is shortened, a short channel effect becomes more apparent, and a capability of controlling, by a control gate of the flash memory, an electron in a floating gate becomes weak. Consequently, a charge tunneling leakage becomes increasingly serious, and directly affects device durability and a data retention capability of the flash memory. As a new type of nonvolatile memory, a resistive random access memory attracts more attention due to advantages such as a simple structure, good compatibility of a complementary metal oxide semiconductor (complementary metal oxide semiconductor, CMOS) process, stackability, implementation of multi-value storage, a high on/off current ratio, and good miniaturization.

A conventional resistive random access memory has a sandwich structure. The resistive random access memory includes a top electrode, a resistive layer, and a bottom electrode. Conventional resistive random access memories include a conductive bridge resistive random access memory mainly using a metal conductive filament and an oxygen defect vacancy resistive random access memory. A conventional resistive random access memory uses metal nanocrystalline at a bottom electrode of a storage unit. In other words, a layer of a metal thin film is deposited between the bottom electrode of the storage unit and a resistive dielectric layer, and the metal thin film is rapidly annealed at a high temperature, so that the metal thin film is dispersed into metal nanocrystalline with a specific size and shape. Cracking of the metal thin film is random. Therefore, the size and distribution of the metal nanocrystalline are uncontrollable, and performance consistency in conventional resistive random access memories is poor.

### SUMMARY

The subject matter of the present invention is defined by the appended claims. Further embodiments not covered by the claims are provided for background information to promote a deeper understanding of the invention. In view of the foregoing problem, embodiments of this disclosure are intended to provide a resistive random access memory, a chip, an electronic apparatus, and an electronic device, to improve storage performance.

The present invention is directed to a resistive random access memory. The resistive random access memory includes a first electrode layer, a resistive layer, and a second electrode layer according to the independent device claim 1. A through hole formed through etching is used, and an electrode is deposited in the through hole, so that a position of the second electrode can be determined based on an expectation. Because the position of the second electrode is determined, in the resistive random access memory, conductive filaments that are even and consistent in both time and space may be formed between first electrodes and the second electrodes, to ensure that storage performance of storage nodes in the resistive random access memory is basically consistent with each other, and performance of the storage nodes remains basically stable during long time of using. Compared with a conventional resistive random access memory formed through high-temperature cracking or metal cone transferring, the resistive random access memory in this disclosure can significantly improve performance consistency as well as stability in resistive random access memories.

In a possible implementation of the first aspect, the second electrode is in contact with the resistive dielectric layer. The insulation layer is in contact with the resistive dielectric layer. An electrode surface is flush with an insulation surface, to ensure that distances between the second electrodes and the first electrodes are basically consistent, thereby further improving performance consistency as well as stability in the resistive random access memories.

In a possible implementation of the first aspect, the second electrode includes a conductive portion and an insulation column. The conductive portion has an annular structure or a sleeve structure. An inner through hole is provided inside the annular structure. The sleeve structure is provided with a recess. The insulation column is located in the recess or the inner through hole. An area of the second electrode opposite to the first electrode may be reduced by using the annular structure or the sleeve structure, so that compared with randomness of a position, for generating a conductive filament, of a second electrode with a large area, in this manner, conductive filaments can be generated in a more aggregative and even manner, thereby improving performance consistency as well as stability in memories. In addition, a current can be further reduced, power consumption can be further reduced, and the use of an electrode material can be further reduced, thereby reducing costs. In a possible implementation of the first aspect, a cross section that is of the annular structure or the sleeve structure and that is parallel to the second electrode layer has a shape of a ring or a rectangular ring.

The second conductive material protrudes out of the first conductive material, and is closer to the first electrode layer, so that a localized electric field formed at the top of the second conductive material has greater strength, conductive filaments can be formed by aggregating at the top of the second conductive material, and the conductive filaments can be generated in a more aggregative and even manner, thereby improving overall performance of the memory. In addition, the use of a conductive material can be further reduced, thereby reducing costs.

In some possible implementations of the first aspect, the plurality of second electrodes are evenly arranged in the second electrode layer. A total surface area of the plurality of second electrodes in contact with the resistive layer is not greater than 60%, 50%, 40%, 30%, 20%, or 10% of a surface area of the second electrode layer in contact with the resistive layer. It can be ensured, by limiting density of the second electrodes in the second electrode layer, that ion diffusion and thermal crosstalk in a processing process do not significantly affect performance in the resistive random access memory.

In a possible implementation of the first aspect, the resistive random access memory is a conductive bridge resistive random access memory. The first electrode includes an active metal material such as silver, copper, titanium, and aluminum. The resistive dielectric layer includes tantalum oxide, silicon oxide, zirconia, cadmium oxide, germanium oxide, germanium sulfide, germanium telluride, germanium selenide, copper sulfide, copper telluride, silver sulfide, or a combination thereof. The second electrode includes platinum, iridium, tantalum, tungsten, conductive metal nitride, amorphous carbon, or a combination thereof.

In a possible implementation of the first aspect, the resistive random access memory is an oxygen defect vacancy resistive random access memory. The first electrode includes platinum, iridium, tantalum, tungsten, conductive metal nitride, amorphous carbon, or a combination thereof. The resistive dielectric layer includes hafnium oxide, tantalum oxide, aluminum oxide, titanium oxide, or a combination thereof. The second electrode includes platinum, iridium, tantalum, tungsten, conductive metal nitride, amorphous carbon, or a combination thereof.

In a possible implementation of the first aspect, the first electrode layer is shared by a plurality of storage units and coupled to a bit line. The plurality of second electrodes are respectively corresponding parts of the plurality of storage units, and the plurality of second electrodes are respectively coupled to a plurality of corresponding selectors or transistors.

In a possible implementation of the first aspect, the resistive layer is configured to generate at least one conductive filament in response to a voltage between the first electrode layer and at least one second electrode in the second electrode layer.

According to a second aspect of this disclosure, a chip is provided. The chip includes the resistive random access memory according to the first aspect.

According to a third aspect of this disclosure, an electronic apparatus is provided. The electronic apparatus includes the resistive random access memory according to the first aspect.

According to a fourth aspect of this disclosure, an electronic device is provided. The electronic device includes a power supply apparatus and the resistive random access memory according to the first aspect, and is powered by the power supply apparatus.

The present invention concerns equally a method for manufacturing a resistive random access memory according to the independent method claim 7. A through hole formed through etching is used, and an electrode is deposited in the through hole, so that a position of the second electrode can be determined based on an expectation. Because the position of the second electrode is determined, in the resistive random access memory, conductive filaments that are even and consistent in both time and space may be formed between first electrodes and the second electrodes, to ensure that storage performance of storage nodes in the resistive random access memory is basically consistent with each other, and performance of the storage nodes remains basically stable during long time of using. Compared with a conventional resistive random access memory formed through high-temperature cracking or metal cone transferring, the resistive random access memory in this disclosure can significantly improve performance consistency as well as stability in resistive random access memories.

In a possible implementation of the fifth aspect, the forming a plurality of through holes in the insulation layer includes etching the insulation layer to form the plurality of through holes. It can be ensured, by using an etching process, that a second electrode is at an expected position and a size of the second electrode is a designed size, thereby ensuring performance consistency of second electrodes corresponding to storage units, and further improving performance consistency as well as stability in memories.

In a possible implementation of the fifth aspect, the forming a plurality of second electrodes in at least a part of the plurality of through holes includes: depositing a conductive material on an insulation layer and in the plurality of through holes; depositing an insulation material on a surface of the conductive material to form an intermediate structure; and polishing the intermediate structure until the insulation layer is exposed, to form the plurality of second electrodes. An electrode surface may be flush with an insulation surface by using deposition and polishing processes, to ensure that distances between the second electrodes and first electrodes are basically consistent, thereby further improving performance consistency as well as stability in resistive random access memories. In addition, an annular structure or a sleeve structure may be formed by using the foregoing manner. This reduces an area of the second electrode opposite to the first electrode, so that compared with randomness of a position, for generating a conductive filament, of a second electrode with a large area, in this manner, conductive filaments can be generated in a more aggregative and even manner, thereby improving overall performance of the memory. In addition, the use of a conductive material can be further reduced, thereby reducing costs. In a possible implementation of the fifth aspect, a cross section that is of the annular structure or the sleeve structure and that is parallel to the second electrode layer has a shape of a ring or a rectangular ring.

In a possible implementation of the fifth aspect, the forming a plurality of second electrodes in at least a part of the plurality of through holes includes: depositing a conductive material in the plurality of through holes and on a surface of the insulation layer until conductive materials are completely filled in the plurality of through holes; and polishing the conductive material on the surface of the insulation layer until the insulation layer is exposed, to form the plurality of second electrodes. An electrode surface may be flush with an insulation surface by using deposition and polishing processes, to ensure that distances between the second electrodes and first electrodes are basically consistent, thereby further improving performance consistency as well as stability in resistive random access memories.

An electrode surface may be flush with an insulation surface by using deposition and polishing processes, to ensure that distances between the second conductive material in the second electrodes and first electrodes are basically consistent, thereby further improving performance consistency as well as stability in resistive random access memories. In addition, in the second electrode, compared with the first conductive material, the second conductive material protrudes out of the first conductive material, and is closer to the first electrode layer, so that a localized electric field formed at the top of the second conductive material has greater strength, conductive filaments can be formed by aggregating at the top of the second conductive material, and the conductive filaments can be generated in a more aggregative and even manner, thereby improving overall performance of the memory. In addition, the use of a conductive material can be further reduced, thereby reducing costs.

In some possible implementations of the fifth aspect, the plurality of second electrodes are evenly arranged in the second electrode layer. A total surface area of the plurality of second electrodes in contact with the resistive dielectric layer is not greater than 60%, 50%, 40%, 30%, 20%, or 10% of a surface area of the second electrode layer in contact with the resistive dielectric layer. It can be ensured, by limiting density of the second electrodes in the second electrode layer, that ion diffusion and thermal crosstalk in a processing process do not significantly affect performance in the resistive random access memory.

In a possible implementation of the fifth aspect, the resistive random access memory is a conductive bridge resistive random access memory. The first electrode includes an active metal material such as silver, copper, titanium, and aluminum. The resistive dielectric layer includes tantalum oxide, silicon oxide, zirconia, cadmium oxide, germanium oxide, germanium sulfide, germanium telluride, germanium selenide, copper sulfide, copper telluride, silver sulfide, or a combination thereof. The second electrode includes platinum, iridium, tantalum, tungsten, conductive metal nitride, amorphous carbon, or a combination thereof.

In a possible implementation of the fifth aspect, the resistive random access memory is an oxygen defect vacancy resistive random access memory. The first electrode includes platinum, iridium, tantalum, tungsten, conductive metal nitride, amorphous carbon, or a combination thereof. The resistive dielectric layer includes hafnium oxide, tantalum oxide, aluminum oxide, titanium oxide, or a combination thereof. The second electrode includes platinum, iridium, tantalum, tungsten, conductive metal nitride, amorphous carbon, or a combination thereof.

It should be understood that the content described in the summary is not intended to limit key or important features of embodiments of this disclosure or limit the scope of this disclosure. Other features of this disclosure will be readily understood through the following descriptions.

### BRIEF DESCRIPTION OF DRAWINGS

The foregoing and other features, advantages, and aspects of embodiments of this disclosure become more apparent with reference to the accompanying drawings and with reference to the following detailed descriptions. In the accompanying drawings, same or similar reference numerals represent same or similar elements.
FIG. 1 is a diagram of a structure of a resistive unit of a conventional resistive random access memory;
FIG. 2 is a diagram of forming a conductive filament in a resistive unit of a conventional resistive random access memory;
FIG. 3 is a schematic of a circuit of a part of storage units of a resistive random access memory;
FIG. 4 is a schematic of a circuit of a part of storage units of another resistive random access memory;
FIG. 5A is a diagram of a structure of a resistive random access memory according to some embodiments of this disclosure;
FIG. 5B is a diagram of an annular structure and a sleeve structure of a second electrode in FIG. 5A;
FIG. 6 is a diagram of a structure of a part of processes for manufacturing a resistive random access memory according to some other embodiments of this disclosure;
FIG. 7 is a diagram of a structure of a part of processes for manufacturing a resistive random access memory according to some other embodiments of this disclosure;
FIG. 8 is a diagram of a structure of a part of processes for manufacturing a resistive random access memory according to some other embodiments of this disclosure;
FIG. 9 is a diagram of a structure of a part of processes for manufacturing a resistive random access memory according to some other embodiments of this disclosure;
FIG. 10 is a diagram of a structure of a part of processes for manufacturing a resistive random access memory according to some other embodiments of this disclosure;
FIG. 11 is a diagram of a structure of a part of processes for manufacturing a resistive random access memory according to some other embodiments of the invention;
FIG. 12 is a diagram of a structure of a part of processes for manufacturing a resistive random access memory according to some other embodiments of the invention. and
FIG. 13 is a flowchart of a method for manufacturing a resistive random access memory according to some embodiments of the invention.

### DESCRIPTION OF EMBODIMENTS

Embodiments of this disclosure are described in more detail in the following with reference to the accompanying drawings. Although some embodiments of this disclosure are shown in the accompanying drawings, it should be understood that this disclosure can be implemented in various forms, and should not be construed as being limited to embodiments described herein, and instead, these embodiments are provided for a more thorough and complete understanding of this disclosure. It should be understood that the accompanying drawings and embodiments of this disclosure are merely used as examples and are not intended to limit the protection scope of this disclosure.

In the descriptions of embodiments of this disclosure, the term "including" and similar terms thereof shall be understood as non-exclusive inclusions, that is, "including but not limited to". The term "based on" should be understood as "at least partially based on". The term "one embodiment" or "this embodiment" should be understood as "at least one embodiment". The terms "first", "second", and the like may indicate different objects or a same object. The term "and/or" represents at least one of two items associated with the term. For example, "A and/or B" indicates A, B, or A and B. Other explicit and implicit definitions may also be included below.

It should be understood that, in the technical solutions provided in embodiments of this application, some repeated parts may not be described again in the following descriptions of specific embodiments, but it should be considered that these specific embodiments are mutually referenced and may be combined.

A resistive random access memory usually includes a plurality of storage units, and each storage unit includes a resistive unit. The resistive unit is of a sandwich structure, and a resistive dielectric layer is disposed between a top electrode and a bottom electrode. In an operation process of the resistive random access memory, a conductive filament that passes through the resistive dielectric layer is generated between the top electrode and the bottom electrode, to change a resistance between the top electrode and the bottom electrode, thereby changing an information storage status of the storage unit of the resistive random access memory. A conventional resistive random access memory is a conductive bridge resistive random access memory. A metal conductive filament between a top electrode and a bottom electrode is formed to change an information storage status of a storage unit of the resistive random access memory. Another conventional resistive random access memory is an oxygen defect vacancy resistive random access memory. Under an action of an electric field, freely moving O²⁻ is ionized and a vacancy with a positive charge is formed at an original position, to form a conduction band channel between a top electrode and a bottom electrode to change a resistance of a storage unit of the resistive random access memory, thereby changing an information storage status of the storage unit of the resistive random access memory.

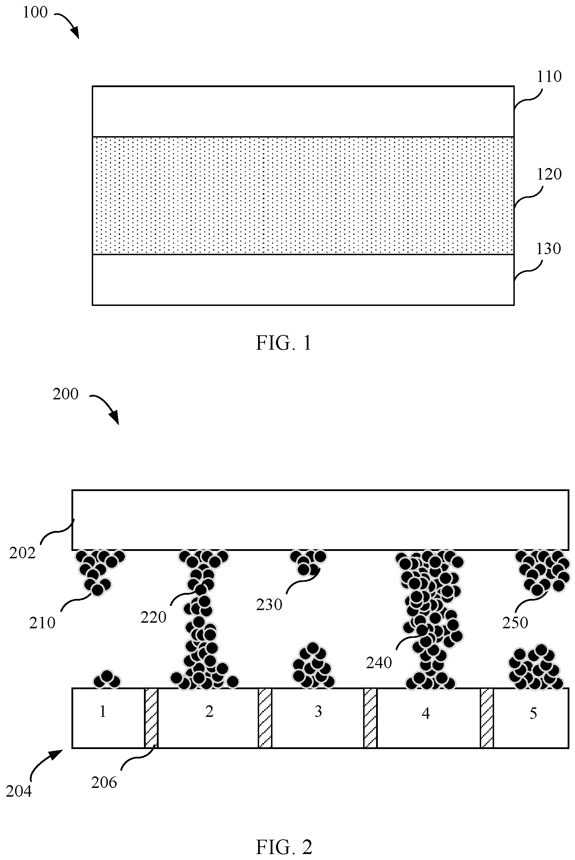

FIG. 1 is a diagram of a structure of a resistive unit 100 in a storage unit of a conventional resistive random access memory. The resistive random access memory includes a plurality of storage units, and each storage unit includes one resistive unit. The resistive unit 100 is of a sandwich structure, and includes a top electrode 110, a resistive dielectric layer 120, and a bottom electrode 130. There are two operation manners of the resistive random access memory 100: a unipolar operation manner and a bipolar operation manner. A unipolar operation behavior depends on an amplitude of an applied voltage rather than a voltage polarity, and a bipolar operation behavior depends on a polarity of the applied voltage. Compared with the bipolar operation behavior, the unipolar operation behavior has higher energy consumption, poor stability, and poor performance consistency. Storage mechanisms of resistive random access memories 100 mainly include a conductive bridge resistive random access memory mainly using a metal conductive filament and an oxygen defect vacancy resistive random access memory mainly using an oxygen defect vacancy conductive filament. A specific storage mechanism of a resistive random access memory is mainly determined based on selection of a specific material of each layer.

FIG. 2 is a diagram of forming a conductive filament in a resistive unit of a conventional resistive random access memory 200. In FIG. 2, the resistive random access memory 200 includes five resistive units, which correspond to a position 1, a position 2, a position 3, a position 4, and a position 5 in FIG. 2 respectively. The resistive random access memory 200 includes a plate top electrode 202, a plate bottom electrode 204, and a dielectric material (not shown) located between the top electrode 202 and the bottom electrode 204, and the resistive units are separated by insulation layers 206 in the bottom electrode 204. Because electric fields generated at all positions of the plate electrode are uniform, a position for generating the conductive filament is completely determined by a defect position and a quantity of defects randomly generated in a deposition process of a resistive dielectric layer. Consequently, the position for generating the conductive filament is uncontrollable, and a thickness of the formed conductive filament is uncontrollable. As a result, a resistance of the resistive random access memory is uncontrollable. As shown in FIG. 2, a conductive filament 210 at the position 1, a conductive filament 220 at the position 2, a conductive filament 230 at the position 3, a conductive filament 240 at the position 4, and a conductive filament 250 at the position 5 have different breaking conditions and thicknesses. As a result, resistances between the top electrode 202 and the bottom electrode 204 are different. Both formation and breakage of the conductive filament determine a resistance status of the resistive dielectric layer, thereby determining an information storage status of the resistive random access memory 200. However, the conductive filament is formed through migration of a metal cation or O²⁻. Ion migration is affected by material properties (such as electrode potential of a metal electrode material, a dielectric constant of a dielectric material, and an interface and bulk defect distribution of the dielectric material), a programming condition, and a localized temperature field inside a device. This causes randomness of ion generation and migration, and finally causes a problem of performance inconsistency in resistive random access memories 100 as well as a stability problem of the device. The problem of performance inconsistency includes inconsistency between devices (device-to-device, D2D) and cycles (cycle-to-cycle, C2C) in the resistive random access memories. The stability problem includes a durability problem and a data retention capability problem. Therefore, it is expected to improve a control capability and uniformity for forming the conductive filament of the resistive random access memory.

As described above, conventional resistive random access memories such as a conductive bridge resistive random access memory and an oxygen defect vacancy resistive random access memory have problems of poor performance consistency and poor stability. Specifically, a conventional resistive random access memory uses metal nanocrystalline at a bottom electrode of a resistive unit in a storage unit of the conventional resistive random access memory. In other words, a layer of a metal thin film is deposited between the bottom electrode of the resistive unit and a resistive dielectric layer, and the metal thin film is rapidly annealed at a high temperature, so that the metal thin film is dispersed into metal nanocrystalline with a specific size and shape. Compared with that of an original plate metal electrode, a position of the protruding metal nanocrystalline has a specific localized electric field enhancement effect, and a position at which an electric field is enhanced can promote ion migration, thereby enhancing a capability of controlling a position for generating a conductive filament. However, the metal nanocrystalline requires the metal thin film to crack at a high temperature of 400°C to 800°C. This is not conducive to integration of a back end of line of resistive random access memory manufacturing. In addition, the cracking of the metal thin film is random. Therefore, a size and distribution of the metal nanocrystalline are uncontrollable, and improvement on performance inconsistency as well as stability of devices is limited. Another conventional resistive random access memory uses an ordered metal electrode in a cone shape. An electrode template in a pyramid cone shape is prepared by etching an inverted pyramid shape on a silicon wafer, and an electrode in an inverted pyramid shape is prepared after a metal thin film is deposited on the template. The metal electrode in a pyramid cone shape is transferred, by using a transferring and stripping technology, to a base for manufacturing the resistive random access memory. The size and distribution of the nanocrystalline are uncontrollable, while sizes and distribution of the metal electrode in a cone shaped prepared by using the template are more controllable. In addition, compared with the plate electrode, the metal electrode in a pyramid cone shape has a position-based electric field enhancement effect, and can enhance Schottky emission of electrons at the tip of the pyramid, thereby controlling a position for generating a conductive filament. However, in this solution, the electrode template in a pyramid cone shape needs to be prepared by using an etching process. A size of the prepared electrode in a pyramid cone shape is large (for example, greater than 1 micrometer), and a spacing between pyramid particles is great (for example, greater than 1 micrometer). This is not conducive to miniaturization of the resistive random access memory. In addition, a localized electric field enhancement effect is reflected only at the tip of the electrode in a pyramid cone shape, and plate electrodes are still in a remaining region of the electrode in a pyramid cone shape and spacing regions between electrodes in pyramid cone shapes. Generation of conductive filaments at the plate electrodes is inevitable and is still random. Therefore, improvement on performance inconsistency as well as stability in resistive random access memories is limited.

In this disclosure, the resistive random access memory includes a plurality of storage units, each storage unit includes a resistive unit, and the resistive unit includes a first electrode layer and a second electrode layer. A plurality of through holes are provided in the second electrode layer, and a plurality of second electrodes are disposed in the plurality of through holes, so that the second electrodes can be at an expected position. When a conductive filament is generated between the electrode and a first electrode opposite to the electrode, the conductive filament is basically generated at the expected position. In this way, generation randomness of the conductive filament can be reduced, and shape uniformity of the conductive filament can be improved, thereby improving performance consistency in the resistive random access memories and improving stability of a conductive filament device. In addition, a requirement for an external current can be effectively reduced, thereby helping reduce energy consumption. In addition, the resistive random access memory according to this embodiment of this disclosure may be further compatible with a back end of line.

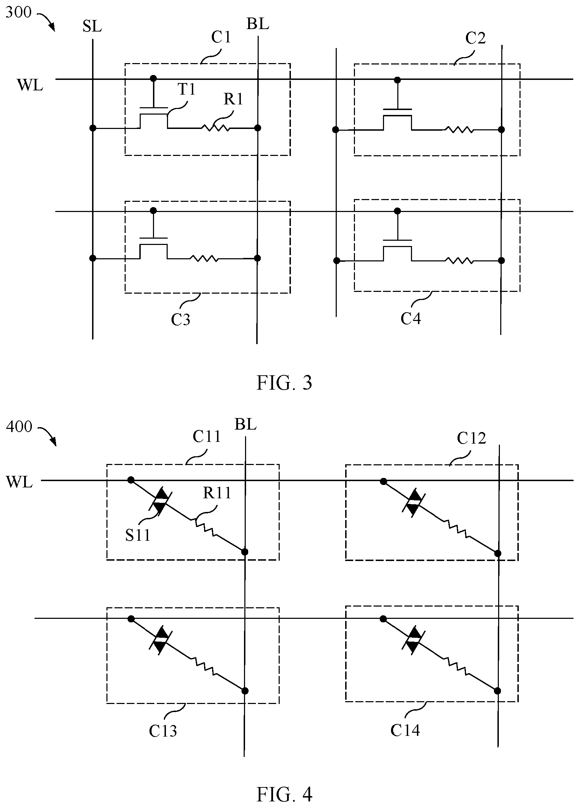

FIG. 3 is a diagram of a circuit of a part of storage units 300 of a resistive random access memory. The part of storage units 300 is of a single-transistor single-resistive unit architecture, and includes, for example, four storage units C1, C2, C3, and C4. It may be understood that the resistive random access memory may include more storage units. In FIG. 3, each storage unit includes a transistor and a resistive unit coupled to the transistor. The storage unit C1 is used as an example. The storage unit C1 includes a transistor T1 and a resistive unit R1. A gate of the transistor T1 is coupled to a word line WL, a source of the transistor T1 is coupled to a source line SL, and a drain of the transistor T1 is coupled to one end of the resistive unit R1, for example, a bottom electrode or a second electrode. The other end of the resistive unit R1, for example, a top electrode or a first electrode, is coupled to a bit line BL. The storage unit C1 may operate in a write mode or a read mode. For example, in the write mode, when "1" (SET) is written, the word line WL is connected to a high level V_{dd}, the bit line BL is connected to a write voltage V_{w1}, and the source line SL is grounded. When "0" (RESET) is written, the word line WL is connected to the high level V_{dd}, the bit line BL is grounded, and the source line SL is connected to a write voltage V_{w2}. Voltage polarities of the write voltage V_{w1} and the write voltage V_{w2} are opposite, and amplitudes depend on specific parameters of the resistive random access memory, and may be the same or may be different.

FIG. 4 is a diagram of a circuit of a part of storage units 400 of another resistive random access memory. The part of storage units 400 is of a single-selector single-resistive unit architecture, and includes, for example, four storage units C11, C12, C13, and C14. It may be understood that the resistive random access memory may include more storage units. In FIG. 4, each storage unit includes a selector and a resistive unit coupled to the selector. The storage unit C11 is used as an example. The storage unit C11 includes a selector S11 and a resistive unit R11. One end of the selector S11 is coupled to a word line WL, and one end of the selector S11 is coupled to one end of the resistive unit R11, for example, a top electrode or a first electrode. The other end of the resistive unit R11, for example, a bottom electrode or a second electrode, is coupled to a bit line BL. The storage unit C11 may operate in a write mode or a read mode. For example, in the write mode, when "1" (SET) is written, the word line WL of the storage unit C11 is connected to a write voltage V_{w1}, and the bit line BL is grounded. When "0" (RESET) is written, the word line WL of the storage unit C11 is grounded, and the bit line BL is connected to a write voltage V_{w2}. Voltage polarities of the write voltage V_{w1} and the write voltage V_{w2} are opposite, and amplitudes depend on specific parameters of the resistive random access memory, and may be the same or may be different.

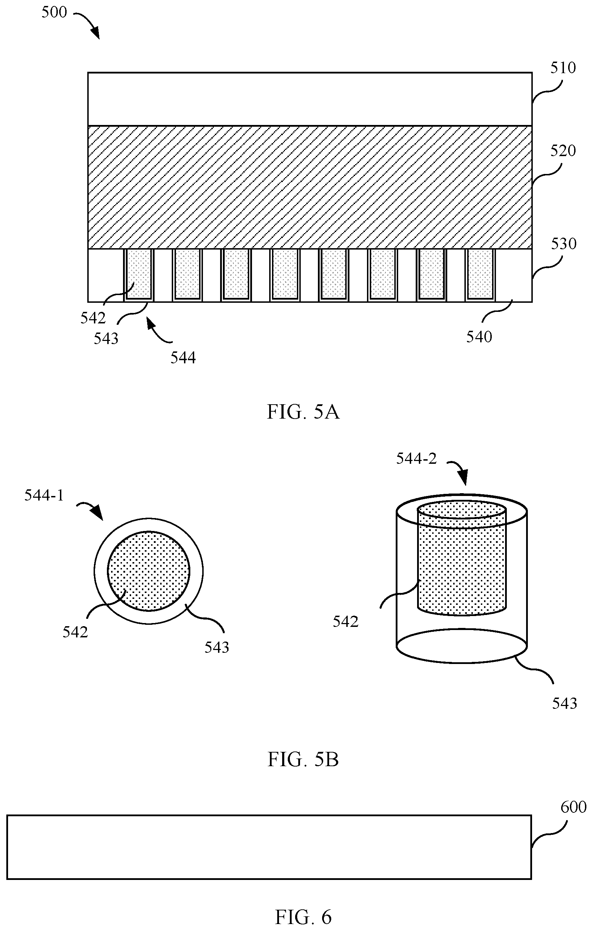

FIG. 5A is a diagram of a structure of some resistive units in a resistive random access memory 500 according to some embodiments of this disclosure. The resistive random access memory 500 may include a plurality of storage units, each storage unit includes one resistive unit, and each resistive unit is configured to store data of one bit. For example, when the resistive unit is in a low resistance state, a value "0" is stored. When the resistive unit is in a high resistance state, a value "1" is stored. For ease of understanding, FIG. 5A shows only a structure of some resistive units of the resistive random access memory 500. The resistive random access memory 500 includes a first electrode layer 510, a resistive dielectric layer 520, and a second electrode layer 530. The resistive dielectric layer 520 is located between the first electrode layer 510 and the second electrode layer 530. The second electrode layer 530 includes an insulation layer 540, a plurality of through holes, and a plurality of second electrodes. The plurality of through holes are provided in the insulation layer 540. In an embodiment, the first electrode layer 510 may be coupled, through an interconnection line, to another device, for example, a device coupled to the bit line in FIG. 3, and the plurality of second electrodes in the second electrode layer 530 may be coupled, through a plurality of interconnection lines, to some other devices, for example, the plurality of transistors in FIG. 3. This is not limited in this disclosure. Although the first electrode layer 510 is shown as a whole as a first electrode in FIG. 5A, this is merely an example and is not intended to limit the scope of this disclosure. In some other embodiments, the first electrode layer 510 may alternatively include a plurality of first electrodes corresponding to the plurality of second electrodes. Refer to FIG. 4. The plurality of second electrodes may be, for example, ends that are of a plurality of corresponding resistive units (including the resistive unit R11) in the plurality of storage units C11, ..., and C14 in FIG. 4 and that are respectively connected to a plurality of selectors, and the first electrode layer may be ends that are of the plurality of storage units and that are connected to a same bit line BL. For example, one second electrode may be one end that is of the resistive unit R11 and that is connected to the selector S11, and the first electrode layer may be ends that are of the storage units C11 and C13 and that are connected to the bit line BL. Similarly, refer to FIG. 3. The plurality of second electrodes may be, for example, ends that are of a plurality of corresponding resistive units (including the resistive unit R1) in the plurality of storage units C1, ..., and C4 in FIG. 3 and that are respectively connected to a plurality of transistors, and the first electrode layer may be ends that are of the plurality of storage units and that are connected to a same bit line BL. For example, one second electrode may be one end that is of the resistive unit R1 and that is connected to the transistor T1, and the first electrode layer may be ends that are of the storage units C1 and C3 and that are connected to the bit line BL. The first electrode is one end that is in the resistive unit and that is configured to receive a signal of the bit line BL, and the second electrode is one end that is connected to a selection device such as the selector or the transistor.

In an embodiment, the resistive random access memory 500 is a conductive bridge resistive random access memory. The first electrode includes an electrochemically active metal material whose ionization energy is between 570 kJ/mol and 740 kJ/mol and electrode potential is between -1.7 eV and +0.8 eV, for example, silver, copper, titanium, or a combination thereof. The resistive dielectric layer includes tantalum oxide, silicon oxide, zirconia, cadmium oxide, germanium oxide, germanium sulfide, germanium telluride, germanium selenide, copper sulfide, copper telluride, silver sulfide, or a combination thereof. The second electrode includes an electrochemically inert metal material whose ionization energy is greater than 740 kJ/mol or electrode potential is greater than 0.8 eV, for example, platinum, iridium, tantalum, tungsten, conductive metal nitride, amorphous carbon, or a combination thereof.

In another embodiment, the resistive random access memory 500 is an oxygen defect vacancy resistive random access memory. The first electrode includes an electrochemically inert metal material whose ionization energy is greater than 740 kJ/mol or electrode potential is greater than 0.8 eV, for example, platinum, iridium, tantalum, tungsten, conductive metal nitride, amorphous carbon, or a combination thereof. The resistive dielectric layer includes hafnium oxide, tantalum oxide, aluminum oxide, titanium oxide, or a combination thereof. The second electrode includes an electrochemically inert metal material whose ionization energy is greater than 740 kJ/mol or electrode potential is greater than 0.8 eV, for example, platinum, iridium, tantalum, tungsten, conductive metal nitride, amorphous carbon, or a combination thereof.

A second electrode 544 in the plurality of second electrodes is used as an example for descriptions. The second electrode 544 is at least partially located in one of the plurality of through holes, and the plurality of second electrodes are insulated from each other. In FIG. 5A, each second electrode may correspond to one end of one resistive unit, and each second electrode and a first electrode opposite to the second electrode may form one resistive unit, to store information of one bit. A through hole formed through etching is used, and an electrode is deposited in the through hole, so that a position of the second electrode can be determined based on an expectation. Because the position of the second electrode is determined, for example, each second electrode is aggregated on a surface of a predetermined region of the second electrode layer, a conductive filament is formed on the surface of the predetermined region. When applied voltages are consistent, in the resistive random access memory, conductive filaments that are even and consistent in both time and space may be formed between first electrodes and the second electrodes, to ensure that storage performance of storage nodes in the resistive random access memory is basically consistent with each other, and performance of the storage nodes remains basically stable during long time of using. Compared with a conventional resistive random access memory formed through high-temperature cracking or metal cone transferring, the resistive random access memory in this disclosure can significantly improve performance consistency as well as stability in resistive random access memories.

In FIG. 5A, the second electrode 544 may include a first electrode surface opposite to the resistive dielectric layer 520. The insulation layer 540 includes a first insulation surface opposite to the resistive dielectric layer, and the first insulation surface is flush with the first electrode surface. The electrode surface is flush with the insulation surface, to ensure that distances between the second electrodes and the first electrode 510 are basically consistent, thereby further improving performance consistency as well as stability in the resistive random access memories. Although it is shown in FIG. 5A that the first electrode surface of the second electrode is flush with the first insulation surface of the insulation layer 540, this is merely an example and is not intended to limit the scope of this disclosure. In some embodiments, the first electrode surface of the second electrode may not be flush with the first insulation surface of the insulation layer 540, for example, may be higher or lower than the first insulation surface of the insulation layer.

In FIG. 5A, the second electrode 544 may have a conductive portion 543 and an insulation column 542. The conductive portion 543 has a sleeve structure, the sleeve structure is provided with a recess, and the insulation column 542 is located in the recess. Alternatively, the conductive portion 543 may have an annular structure. Compared with the sleeve structure, the annular structure has openings on both the first insulation surface of the insulation layer 540 and a second insulation surface opposite to the first insulation surface, and is provided with an inner through hole. In the inner through hole, the insulation column 542 may extend and pass through the inner through hole. FIG. 5B is a diagram of an annular structure and a sleeve structure of the second electrode 544. FIG. 5B shows a top view 544-1 of the second electrode 544 having the sleeve structure and a stereoscopic view 544-2 of the second electrode 544. In some other embodiments, the second electrode 544 may have an annular electrode, in other words, the insulation column 542 has a same height as the conductive portion 543, so that the insulation column 542 extends and passes through the second electrode 544 in a vertical direction. A cross section that is of the annular structure or the sleeve structure and that is parallel to the second electrode layer has a shape of a ring or a rectangular ring. Alternatively, the conductive portion 543 may have another cross-sectional shape. An area of the second electrode opposite to the first electrode may be reduced by using the annular structure or the sleeve structure, so that compared with randomness of a position, for generating a conductive filament, of a second electrode with a large area, in this manner, conductive filaments can be generated in a more aggregative and even manner, thereby improving overall performance of the memory, for example, performance consistency and stability described above. In addition, the use of a metal material can be further reduced, thereby reducing costs. Alternatively, the conductive portion 543 may be completely filled in the through hole and does not have the insulation column 542.

In an embodiment, the plurality of second electrodes are evenly arranged in the second electrode layer 530. A total surface area of the plurality of second electrodes in contact with the resistive dielectric layer is not greater than 60%, 50%, 40%, 30%, 20%, or 10% of a surface area of the second electrode layer in contact with the resistive dielectric layer. It is found through research that if density of the second electrodes in the second electrode layer is high, a problem of ion diffusion may occur in a processing process. In addition, because resistance performance is related to a temperature, high density of the second electrodes may further cause thermal crosstalk that affects a resistance. It can be ensured, by limiting the density of the plurality of second electrodes in the second electrode layer 530, that ion diffusion and thermal crosstalk in the processing process do not significantly affect performance in the resistive random access memory.

FIG. 6 is a diagram of a structure of a part of processes for manufacturing a resistive random access memory according to some other embodiments of this disclosure. In an embodiment, a second insulation layer 600 may be formed on a support substrate or another substrate. For example, the second insulation layer 600 may be deposited by using a method such as physical vapor deposition or atomic layer deposition. It may be understood that the second insulation layer 600 may alternatively be formed by using another forming or deposition method.

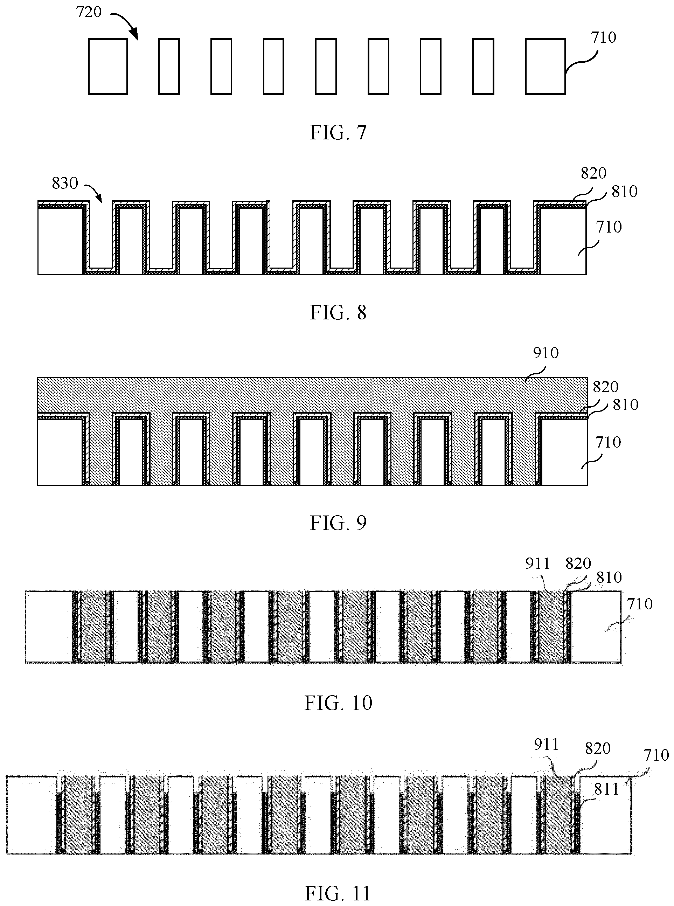

FIG. 7 is a diagram of a structure of a part of processes for manufacturing a resistive random access memory according to some other embodiments of this disclosure. In an embodiment, after the second insulation layer 600 is formed, a plurality of through holes 720 may be etched in the second insulation layer 600 to form an insulation layer 710 having the plurality of through holes 720. It may be understood that the plurality of through holes may alternatively be formed by using another insulation material removal process.

FIG. 8 is a diagram of a structure of a part of processes for manufacturing a resistive random access memory according to some other embodiments of this disclosure. In an embodiment, after the insulation layer 710 is formed, a stack of a plurality of layers of conductive materials may be deposited on a surface of the insulation layer 710 to form stacks. For example, a first conductive material 810 is deposited on the surface of the insulation layer 710, and a second conductive material 820 is deposited on the first conductive material 810. Although only two layers of conductive materials are shown herein, this is merely an example and is not intended to limit the scope of this disclosure. In some embodiments, the first conductive material 810 and the second conductive material 820 may be deposited alternately to form a stack of more layers of conductive materials. A part of the plurality of conductive materials in the through hole has a recess, for example, a recess 830. It may be understood that another conductive material forming process may alternatively be used to form the stack of the plurality of layers of conductive materials.

FIG. 9 is a diagram of a structure of a part of processes for manufacturing a resistive random access memory according to some other embodiments of this disclosure. In an embodiment, after the plurality of layers of conductive materials are alternately deposited to form stacks, the plurality of layers of conductive materials in the recess 830, for example, the first conductive material 810 and the second conductive material 820, may be directionally etched by using an etching process. Then, an insulation material 910 may be deposited on a surface of the structure after the etching. Although etching and deposition processes are used herein, other material removal and material forming processes may be used.

FIG. 10 is a diagram of a structure of a part of processes for manufacturing a resistive random access memory according to some other embodiments of this disclosure. In an embodiment, after the insulation material 910 is formed, a part on the insulation layer 710 may be removed by using a polishing process until the insulation layer 710 and an insulation column 911 are exposed. In addition, electrode surfaces of the first conductive material 810 and the second conductive material 820 are flush with surfaces of the insulation layer 710 and the insulation column 911.

FIG. 11 is a diagram of a structure of a part of processes for manufacturing a resistive random access memory according to some other embodiments of the invention. In an embodiment, a part of the first conductive material 811 may be etched by using a selective etchant after an intermediate structure shown in FIG. 10, so that the second conductive material 820 protrudes out of the first conductive material 810. In other words, a size of the second conductive material 820 in a first direction (horizontal direction) perpendicular to the insulation layer 710 is greater than a size of the first conductive material 810 in the first direction, to form a sawtooth-shaped second electrode. The second conductive material protrudes out of the first conductive material. In other words, the second conductive material 820 is closer to the first electrode layer, so that conductive filaments can be formed by aggregating at the top of the second conductive material 820, and the conductive filaments can be generated in a more aggregative and even manner, thereby improving overall performance of the memory. In addition, the use of a metal material can be further reduced, thereby reducing costs. Alternatively, the first conductive material 810 may not be etched, but the first conductive material 810 and the second conductive material 820 are used as a whole as the second electrode. It may be understood that when more layers of second conductive materials 820 are deposited in FIG. 8, more protruding second conductive materials may be formed in FIG. 11.

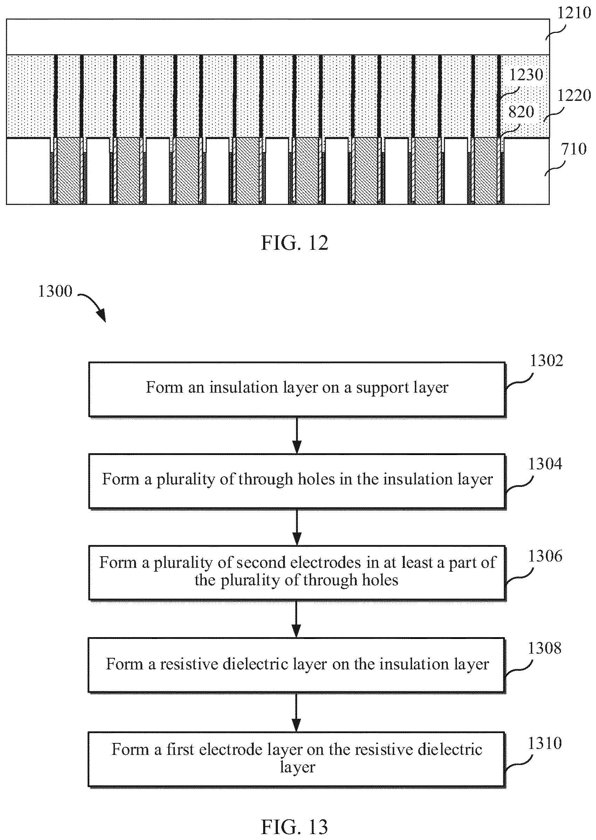

FIG. 12 is a diagram of a structure of a part of processes for manufacturing a resistive random access memory according to some other embodiments of the invention. In an embodiment of the invention, a resistive dielectric layer 1220 may be deposited on the structure in FIG. 11, and a first electrode layer 1210 may be deposited on the resistive dielectric layer 1220. The first electrode layer 1210 may be formed as a whole and includes a single first electrode. Alternatively, the first electrode layer 1210 may include a plurality of first electrodes corresponding to the plurality of second electrodes. In an operation process of the resistive random access memory, a plurality of even and stable conductive filaments 1230 may be formed between the second conductive material 820 and the first electrode layer 1210 based on voltages on the first electrode layer 1210 and the plurality of second electrodes. In addition, because the etching and deposition processes may be miniaturized with process nodes, a size of the through hole, an electrode size, and a material thickness of the resistive random access memory may all be correspondingly adjusted, thereby improving integrity and reducing power consumption. Because the processing processes of the structures shown in FIG. 6 to FIG. 12 may not include using a high-temperature process such as high-temperature cracking, pressure of a back end of line may be reduced, and the processing processes may be compatible with the back end of line.

In the resistive random access memory shown in FIG. 5A and FIG. 12, because second electrodes are regular, even, and flat, and have a relatively small conductive filament forming area, a current providing position can be effectively controlled, and a position for generating a metal cation or an oxygen defect vacancy can be controlled to a maximum extent. In this way, generation randomness of the conductive filament is reduced, and shape uniformity of the conductive filament is improved, thereby improving performance consistency in resistive random access memories, for example, consistency of D2D and C2C. In addition, stability of the resistive random access memory may be further improved, for example, durability and a data retention capability. In addition, the resistive random access memory shown in FIG. 5A and FIG. 12 may further effectively reduce a requirement for an external current, thereby helping reduce energy consumption.

FIG. 13 is a flowchart of a method 1300 for manufacturing a resistive random access memory according to some embodiments of the invention. The method shown in FIG. 13 may be used to manufacture the resistive random access memory shown in FIG. 5A and FIG. 12. Therefore, the aspects described in FIG. 5A to FIG. 12 may be selectively applied to the method 1300.

1302: Form an insulation layer on a support layer. In an embodiment of the invention, the support layer may be, for example, a semiconductor substrate or another base layer that can act as a support. The insulation layer may be formed through deposition, for example, physical vapor deposition or atomic layer deposition. This is not limited in this disclosure.

1304: Form a plurality of through holes in the insulation layer. In an embodiment, for example, the insulation layer may be etched to form the plurality of through holes. It can be ensured, by using an etching process, that a second electrode is at an expected position and a size of the second electrode is a designed size, thereby ensuring performance consistency of second electrodes corresponding to storage units, and further improving performance consistency as well as stability in memories. It may be understood that another insulation material removal process may alternatively be used to form the plurality of through holes by removing a part of an insulation material.

1306: Form a plurality of second electrodes in at least a part of the plurality of through holes. The second electrode is at least partially located in one of the plurality of through holes. In an embodiment, for example, a conductive material may be deposited on the insulation layer and in the plurality of through holes, an insulation material may be deposited on a surface of the conductive material to form an intermediate structure, and the intermediate structure is polished until the insulation layer is exposed to form the plurality of second electrodes. An electrode surface may be flush with an insulation surface by using deposition and polishing processes, to ensure that distances between the second electrodes and first electrodes are basically consistent, thereby further improving performance consistency as well as stability in resistive random access memories. In addition, an annular structure or a sleeve structure may be formed by using the foregoing manner. This reduces an area of the second electrode opposite to the first electrode, so that compared with randomness of a position, for generating a conductive filament, of a second electrode with a large area, in this manner, conductive filaments can be generated in a more aggregative and even manner, thereby improving overall performance of the memory. In addition, the use of a metal material can be further reduced, thereby reducing costs. In a possible implementation of the fifth aspect, a cross section that is of the annular structure or the sleeve structure and that is parallel to the second electrode layer has a shape of a ring or a rectangular ring.

In an embodiment of the invention, a conductive material is deposited in the plurality of through holes and on a surface of the insulation layer until conductive materials are completely filled in the plurality of through holes, and the conductive material on the surface of the insulation layer is polished until the insulation layer is exposed, to form the plurality of second electrodes. An electrode surface may be flush with an insulation surface by using deposition and polishing processes, to ensure that distances between the second electrodes and first electrodes are basically consistent, thereby further improving performance consistency as well as stability in resistive random access memories.

In another emobodiment of the invention, forming a plurality of second electrodes in at least a part of the plurality of through holes includes: alternately depositing a first conductive material and a second conductive material on the insulation layer and in the plurality of through holes, where the second conductive material is different from the first conductive material, and a recess is formed in the through hole; etching the first conductive material and the second conductive material under the recess to form an intermediate through hole; depositing an insulation material on a surface of the first conductive material or the second conductive material and in the intermediate through hole to form an intermediate structure; polishing the intermediate structure until the insulation layer is exposed; and selectively etching the first conductive material to form the plurality of second electrodes. An electrode surface may be flush with an insulation surface by using deposition and polishing processes, to ensure that distances between the second conductive material in the second electrodes and first electrodes are basically consistent, thereby further improving performance consistency as well as stability in resistive random access memories. In addition, the second conductive material protrudes out of the first conductive material. In other words, the second conductive material is closer to the first electrode layer, so that conductive filaments can be formed by aggregating at the top of the second conductive material, and the conductive filament can be generated in a more aggregative and even manner, thereby improving overall performance of the memory. In addition, the use of a metal material can be further reduced, thereby reducing costs.

In some embodiments of the invention, the plurality of second electrodes are evenly arranged in the second electrode layer. A total surface area of the plurality of second electrodes in contact with a resistive dielectric layer is not greater than 60%, 50%, 40%, 30%, 20%, or 10% of a surface area of the second electrode layer in contact with the resistive dielectric layer. It can be ensured, by limiting density of the second electrodes in the second electrode layer, that ion diffusion and thermal crosstalk in a processing process do not significantly affect performance in the resistive random access memory.

1308: Form a resistive dielectric layer on the insulation layer. In an embodiment of the invention, the resistive dielectric layer is formed through deposition, for example, physical vapor deposition or atomic layer deposition. 1310: Form a first electrode layer on the resistive dielectric layer. In an embodiment of the invention, the resistive dielectric layer is formed through deposition, for example, physical vapor deposition or atomic layer deposition. Alternatively, the first electrode layer may be deposited by using another method. In an embodiment of the invention, the resistive random access memory is a conductive bridge resistive random access memory. The first electrode in the method 1300 includes silver, copper, titanium, or a combination thereof. The resistive dielectric layer includes tantalum oxide, silicon oxide, zirconia, cadmium oxide, germanium oxide, germanium sulfide, germanium telluride, germanium selenide, copper sulfide, copper telluride, silver sulfide, or a combination thereof. The second electrode includes platinum, iridium, tantalum, tungsten, conductive metal nitride, amorphous carbon, or a combination thereof. In an embodiment, the resistive random access memory is an oxygen defect vacancy resistive random access memory. The first electrode in the method 1300 includes platinum, iridium, tantalum, tungsten, conductive metal nitride, amorphous carbon, or a combination thereof. The resistive dielectric layer includes hafnium oxide, tantalum oxide, aluminum oxide, titanium oxide, or a combination thereof. The second electrode includes platinum, iridium, tantalum, tungsten, conductive metal nitride, amorphous carbon, or a combination thereof.

Although the subject matter is described in a language specific to structural features and/or method logic actions, it should be understood that the subject matter defined in the appended claims is not necessarily limited to the particular features or actions described above. On the contrary, the particular features and actions described above are merely example forms for implementing the claims.

## Claims

1. A resistive random access memory (500), comprising:
a first electrode layer (510);
a resistive layer (520); and
a second electrode layer (530), wherein the resistive layer (520) is located between the first electrode layer (510) and the second electrode layer (530), and the second electrode layer (530) comprises:
an insulation layer (540);
a plurality of through holes, provided in the insulation layer (540); and
a plurality of second electrodes (544), wherein each of the plurality of second electrodes (544) is at least partially located in one of the plurality of through holes, and the plurality of second electrodes (544) are insulated from each other;
**characterized in that** the second electrode (544) comprises:
a first conductive material (810); and
a second conductive material (820), wherein the second conductive material (820) is different from the first conductive material (810), the second conductive material (820) and the first conductive material (810) are alternately arranged in the through hole, and a size of the second conductive material (820) in a first direction perpendicular to the insulation layer (540) is greater than a size of the first conductive material (810) in the first direction;
wherein the second conductive material (820) protrudes out of the first conductive material (810).

2. The resistive random access memory (500) according to claim 1, wherein the second electrode (544) is in contact with the resistive layer (520), and
the insulation layer (540) is in contact with the resistive layer (520).

3. The resistive random access memory (500) according to claim 1 or 2, wherein the plurality of second electrodes (544) are evenly arranged in the second electrode layer (530); and
a total surface area of the plurality of second electrodes (544) in contact with the resistive layer (520) is not greater than 60% of a surface area of the second electrode layer (530) in contact with the resistive layer (520).

4. The resistive random access memory (500) according to any one of claims 1 to 3, wherein the first electrode layer (510) is shared by a plurality of storage units and coupled to a bit line; and
the plurality of second electrodes (544) are respectively corresponding parts of the plurality of storage units, and the plurality of second electrodes (544) are respectively coupled to a plurality of corresponding selectors or transistors.

5. The resistive random access memory (500) according to any one of claims 1 to 4, wherein the resistive layer (520) is configured to generate at least one conductive filament in response to a voltage between the first electrode layer (510) and at least one second electrode (544) in the second electrode layer (530).

6. An electronic device, comprising:
a power supply apparatus; and
the resistive random access memory (500) according to any one of claims 1 to 5, powered by the power supply apparatus.

7. A method (1300) for manufacturing a resistive random access memory (500), comprising:
forming (1302) an insulation layer (540) on a support layer;
forming (1304) a plurality of through holes in the insulation layer (540);
forming (1306) a plurality of second electrodes (544) in at least a part of the plurality of through holes, wherein each second electrode (544) is at least partially located in one of the plurality of through holes;
forming (1308) a resistive layer (520) on the insulation layer (540); and
forming (1310) a first electrode layer (510) on the resistive layer (520);
wherein the forming (1306) a plurality of second electrodes (544) in at least a part of the plurality of through holes comprises:
alternately depositing a first conductive material (810) and a second conductive material (820) on the insulation layer and in the plurality of through holes, wherein the second conductive material (820) is different from the first conductive material (810), and a recess is formed in the through hole; etching the first conductive material (810) and the second conductive material (820) under the recess to form an intermediate through hole;
depositing an insulation material (910) on a surface of the first conductive material (810) or the second conductive material (820) and in the intermediate through hole to form an intermediate structure;
polishing the intermediate structure until the insulation layer (710) is exposed; and
selectively etching the first conductive material (810) to form the plurality of second electrodes (544) such that the second conductive material (820) protrudes out of the first conductive material (810).

8. The method (1300) according to claim 7, wherein the forming (1304) a plurality of through holes in the insulation layer (540) comprises: etching the insulation layer (540) to form the plurality of through holes.

## Patentansprüche

1. Resistiver Direktzugriffsspeicher (500), umfassend:
eine erste Elektrodenschicht (510);
eine resistive Schicht (520); und
eine zweite Elektrodenschicht (530), wobei sich die resistive Schicht (520) zwischen der ersten Elektrodenschicht (510) und der zweiten Elektrodenschicht (530) befindet und die zweite Elektrodenschicht (530) Folgendes umfasst:
eine Isolierschicht (540);
eine Vielzahl von Durchgangslöchern, die in der Isolierschicht (540) bereitgestellt ist; und
eine Vielzahl zweiter Elektroden (544), wobei sich jede der Vielzahl zweiter Elektroden (544) mindestens teilweise in einem der Vielzahl von Durchgangslöchern befindet und die Vielzahl zweiter Elektroden (544) voneinander isoliert ist;
**dadurch gekennzeichnet, dass** die zweite Elektrode (544) Folgendes umfasst:
ein erstes leitfähiges Material (810); und
ein zweites leitfähiges Material (820), wobei sich das zweite leitfähige Material (820) von dem ersten leitfähigen Material (810) unterscheidet, das zweite leitfähige Material (820) und das erste leitfähige Material (810) abwechselnd in dem Durchgangsloch angeordnet sind und eine Größe des zweiten leitfähigen Materials (820) in einer ersten Richtung senkrecht zu der Isolierschicht (540) größer als eine Größe des ersten leitfähigen Materials (810) in der ersten Richtung ist;
wobei das zweite leitfähige Material (820) aus dem ersten leitfähigen Material (810) vorsteht.

2. Resistiver Direktzugriffsspeicher (500) nach Anspruch 1, wobei die zweite Elektrode (544) mit der resistiven Schicht (520) in Kontakt steht und
die Isolierschicht (540) mit der resistiven Schicht (520) in Kontakt steht.

3. Resistiver Direktzugriffsspeicher (500) nach Anspruch 1 oder 2, wobei die Vielzahl zweiter Elektroden (544) gleichmäßig in der zweiten Elektrodenschicht (530) angeordnet ist; und
eine Gesamtoberflächenzone der Vielzahl zweiter Elektroden (544), die mit der resistiven Schicht (520) in Kontakt steht, nicht größer als 60 % einer Gesamtoberflächenzone der zweiten Elektrodenschicht (530) ist, die mit der resistiven Schicht (520) in Kontakt steht.

4. Resistiver Direktzugriffsspeicher (500) nach einem der Ansprüche 1 bis 3, wobei die erste Elektrodenschicht (510) durch eine Vielzahl von Speichereinheiten gemeinsam genutzt wird und an eine Bitleitung gekoppelt ist; und
es sich bei der Vielzahl zweiter Elektroden (544) jeweils um entsprechende Teile der Vielzahl von Speichereinheiten handelt und die Vielzahl zweiter Elektroden (544) jeweils an eine Vielzahl entsprechender Selektoren oder Transistoren gekoppelt ist.

5. Resistiver Direktzugriffsspeicher (500) nach einem der Ansprüche 1 bis 4, wobei die resistive Schicht (520) dazu konfiguriert ist, als Reaktion auf eine Spannung zwischen der ersten Elektrodenschicht (510) und mindestens einer zweiten Elektrode (544) in der zweiten Elektrodenschicht (530) mindestens einen leitfähigen Strang zu erzeugen.

6. Elektronische Vorrichtung, umfassend:
eine Leistungszufuhreinrichtung; und
den resistiven Direktzugriffsspeicher (500) nach einem der Ansprüche 1 bis 5, der durch die Leistungszufuhreinrichtung mit Leistung versorgt wird.

7. Verfahren (1300) zum Herstellen eines resistiven Direktzugriffsspeichers (500), umfassend:
Bilden (1302) einer Isolierschicht (540) auf einer Trägerschicht;
Bilden (1304) einer Vielzahl von Durchgangslöchern in der Isolierschicht (540);
Bilden (1306) einer Vielzahl zweiter Elektroden (544) in mindestens einem Teil der Vielzahl von Durchgangslöchern, wobei sich jede zweite Elektrode (544) mindestens teilweise in einem der Vielzahl von Durchgangslöchern befindet;
Bilden (1308) einer resistiven Schicht (520) auf der Isolierschicht (540); und
Bilden (1310) einer ersten Elektrodenschicht (510) auf der resistiven Schicht (520);
wobei das Bilden (1306) einer Vielzahl zweiter Elektroden (544) in mindestens einem Teil der Vielzahl von Durchgangslöchern Folgendes umfasst:
abwechselndes Aufbringen eines ersten leitfähigen Materials (810) und eines zweiten leitfähigen Materials (820) auf die Isolierschicht und in die Vielzahl von Durchgangslöchern, wobei sich das zweite leitfähige Material (820) von dem ersten leitfähigen Material (810) unterscheidet und eine Vertiefung in dem Durchgangsloch gebildet wird;
Ätzen des ersten leitfähigen Materials (810) und des zweiten leitfähigen Materials (820) unter der Vertiefung, um ein Zwischendurchgangsloch zu bilden;
Aufbringen eines Isoliermaterials (910) auf eine Oberfläche des ersten leitfähigen Materials (810) oder des zweiten leitfähigen Materials (820) und in das Zwischendurchgangsloch, um eine Zwischenstruktur zu bilden;
Polieren der Zwischenstruktur, bis die Isolierschicht (710) frei liegt; und
selektives Ätzen des ersten leitfähigen Materials (810), um die Vielzahl zweiter Elektroden (544) derart zu bilden, dass das zweite leitfähige Material (820) aus dem ersten leitfähigen Material (810) vorsteht.

8. Verfahren (1300) nach Anspruch 7, wobei das Bilden (1304) einer Vielzahl von Durchgangslöchern in der Isolierschicht (540) Folgendes umfasst: Ätzen der Isolierschicht (540), um die Vielzahl von Durchgangslöchern zu bilden.

## Revendications

1. Mémoire vive résistive (500), comprenant :
une première couche d'électrode (510) ;
une couche résistive (520) ; et
une seconde couche d'électrode (530), dans laquelle la couche résistive (520) est située entre la première couche d'électrode (510) et la seconde couche d'électrode (530), et la seconde couche d'électrode (530) comprend :
une couche isolante (540) ;
une pluralité de trous traversants, prévus dans la couche isolante (540) ; et
une pluralité de secondes électrodes (544), dans laquelle chacune de la pluralité de secondes électrodes (544) est au moins partiellement située dans l'un de la pluralité de trous traversants, et la pluralité de secondes électrodes (544) sont isolées les unes des autres ;
**caractérisée en ce que** la seconde électrode (544) comprend :
un premier matériau conducteur (810) ; et
un second matériau conducteur (820), dans laquelle le second matériau conducteur (820) est différent du premier matériau conducteur (810), le second matériau conducteur (820) et le premier matériau conducteur (810) sont disposés alternativement dans le trou traversant, et la taille du second matériau conducteur (820) dans une première direction perpendiculaire à la couche isolante (540) est supérieure à la taille du premier matériau conducteur (810) dans la première direction ;
dans laquelle le second matériau conducteur (820) dépasse du premier matériau conducteur (810).

2. Mémoire vive résistive (500) selon la revendication 1, dans laquelle la seconde électrode (544) est en contact avec la couche résistive (520), et
la couche isolante (540) est en contact avec la couche résistive (520).

3. Mémoire vive résistive (500) selon la revendication 1 ou 2, dans laquelle la pluralité de secondes électrodes (544) sont disposées uniformément dans la seconde couche d'électrode (530) ; et
la zone de surface totale de la pluralité de secondes électrodes (544) en contact avec la couche résistive (520) ne dépasse pas 60 % de la zone de surface de la seconde couche d'électrode (530) en contact avec la couche résistive (520).

4. Mémoire vive résistive (500) selon l'une quelconque des revendications 1 à 3, dans laquelle la première couche d'électrode (510) est partagée par une pluralité d'unités de stockage et couplée à une ligne de bits ; et
la pluralité de secondes électrodes (544) sont respectivement des parties correspondantes de la pluralité d'unités de stockage, et la pluralité de secondes électrodes (544) sont respectivement couplées à une pluralité de sélecteurs ou de transistors correspondants.

5. Mémoire vive résistive (500) selon l'une quelconque des revendications 1 à 4, dans laquelle la couche résistive (520) est configurée pour générer au moins un filament conducteur en réponse à une tension entre la première couche d'électrode (510) et au moins une seconde électrode (544) dans la seconde couche d'électrode (530).

6. Dispositif électronique, comprenant :
un appareil d'alimentation électrique ; et
la mémoire vive résistive (500) selon l'une quelconque des revendications 1 à 5, alimentée par l'appareil d'alimentation électrique.

7. Procédé (1300) de fabrication d'une mémoire vive résistive (500), comprenant :
la formation (1302) d'une couche isolante (540) sur une couche support ;
la formation (1304) d'une pluralité de trous traversants dans la couche isolante (540) ;
la formation (1306) d'une pluralité de secondes électrodes (544) dans au moins une partie de la pluralité de trous traversants,
dans lequel chaque seconde électrode (544) est au moins partiellement située dans l'un de la pluralité de trous traversants ;
la formation (1308) d'une couche résistive (520) sur la couche isolante (540) ; et
la formation (1310) d'une première couche d'électrode (510) sur la couche résistive (520) ;
dans lequel la formation (1306) d'une pluralité de secondes électrodes (544) dans au moins une partie de la pluralité de trous traversants comprend :
le fait de déposer alternativement un premier matériau conducteur (810) et un second matériau conducteur (820) sur la couche isolante et dans la pluralité de trous traversants, dans lequel le second matériau conducteur (820) est différent du premier matériau conducteur (810), et un évidement est formé dans le trou traversant ;
la gravure du premier matériau conducteur (810) et du second matériau conducteur (820) sous l'évidement pour former un trou traversant intermédiaire ;
le fait de déposer un matériau isolant (910) sur une surface du premier matériau conducteur (810) ou du second matériau conducteur (820) et dans le trou traversant intermédiaire pour former une structure intermédiaire ;
le polissage de la structure intermédiaire jusqu'à ce que la couche isolante (710) soit exposée ; et
la gravure sélective du premier matériau conducteur (810) pour former la pluralité de secondes électrodes (544) de sorte que le second matériau conducteur (820) dépasse du premier matériau conducteur (810).

8. Procédé (1300) selon la revendication 7, dans laquelle la formation (1304) d'une pluralité de trous traversants dans la couche isolante (540) comprend : la gravure de la couche isolante (540) pour former la pluralité de trous traversants.
